# EUROPEAN PATENT APPLICATION

(11) **EP 1 632 811 A1**
(43) Date of publication of application: **08.03.2006**
(21) Application number: 05016249.4
(22) Date of filing: 26.07.2005
(51) Int. Cl.: G03F 7/20, G03F 7/11, C08J 5/18, C09D 127/12, C09D 133/16

(54) **Composition for photoresist protective film, photoresist protective film and photoresist pattern formation process**

(30) Priority: 30.07.2004 JP 2004223813
(71) Applicant: ASAHI GLASS COMPANY LTD., Tokyo 100-8405 (JP)
(72) Inventor: Otozawa, Nobuyuki, Yokohama-shi Kanagawa (JP); Shimada, Toyomichi, Yokohama-shi Kanagawa (JP)
(74) Representative: Müller-Boré & Partner Patentanwälte

(57) **Abstract**

A composition for a photoresist protective film comprising a fluoropolymer having at least one functional group selected from the group consisting of -COOH, -SO₃H, -OP(=O)(OH)₂, -NR₂ and -N⁺R₃Cl⁻ (wherein R represents a C₁₋₄ alkyl group) and having a weight average molecular weight Mw of from 1,000 to 100,000 and a solvent.

## Description

The present invention relates to a composition for a photoresist protective film, a photoresist protective film and a photoresist pattern formation process.

In recent years, a wiring of an integrated circuit becomes finer and development of a lithography process excellent in resolution capable of forming a pattern at a level of submicron size or smaller is in progress. In order to improve the resolution, the wavelength from a light source becomes shorter, and a shift from a KrF excimer laser (248 nm) now in use toward an ArF excimer laser (193 nm) or a F2 laser (157 nm) in future is expected.

Further, in addition to making the wavelength from a light source shorter, an immersion lithography process has been studied to fill a space between a projection lens and a photoresist layer on the surface of a wafer with water or a liquid containing water as the main component. The principle of this method is to improve the resolution by filling a space between a projection lens and a photoresist layer with a liquid having a refractive index higher than that of the air, as the resolution of a photoresist pattern is in inverse proportion to NA (numerical aperture) and NA is in proportion to the refractive index of a medium through which an exposure light passes.

Further, as another method of improving the resolution, development of a photoresist material having a high sensitivity is also in progress. A chemical amplification photoresist material is becoming used wherein a protective group is decomposed by an acid generated by light as a catalyst, and an acid generated by the decomposition of the protective group further accelerates the decomposition reaction.

However, if the chemical amplification photoresist is applied to the immersion lithography process, there is such a problem that an acid generator or the like is eluted from the photoresist layer into water or a liquid containing water as the main component which is in contact with the projection lens, whereby no fine photoresist pattern can be formed. Further, the eluted acid generator or the like may have an influence such as corrosion over the projection lens.

Under these circumstances, it is an object of the present invention to provide a composition for a photoresist protective film, a photoresist protective film and a photoresist pattern formation process, applicable to an immersion lithography process.

The present invention provides a composition for a photoresist protective film comprising a fluoropolymer having at least one functional group selected from the group consisting of -COOH, -SO₃H, -OP(=O)(OH)₂, -NR₂ and -N⁺R₃Cl⁻ (wherein R represents a C₁₋₄ alkyl group) and having a weight average molecular weight Mw of from 1,000 to 100,000 and a solvent.

The present invention further provides a photoresist protective film for immersion lithography formed by using the above composition for a photoresist protective film. The present invention further provides a photoresist pattern formation process, which comprises forming a photoresist layer on the surface of a substrate and further forming the above photoresist protective film thereon to obtain a photoresist substrate, exposing the photoresist substrate by an immersion lithography process, and carrying out an alkali development.

The photoresist protective film of the present invention is not dissolved in water or a liquid containing water as the main component, whereas it is excellent in solubility in an alkali developer. Further, it is excellent in water repellency, whereby in an immersion lithography process using a photoresist substrate having this photoresist protective film formed on the surface, an acid generator or the like will not be eluted from a photoresist layer into water or a liquid containing water as the main component, and the influence over a projection lens will be suppressed, and a fine photoresist pattern having high resolution will be formed.

Further, the composition for a photoresist protective film of the present invention contains a solvent which has no influence over a photoresist layer. Further, with the composition for a photoresist protective film of the present invention, a photoresist protective film having the above excellent properties will be formed.

Further, according to the photoresist pattern formation process of the present invention, a fine photoresist pattern having high resolution will be formed.

Now, the present invention will be described in detail with reference to the preferred embodiments.

The fluoropolymer of the present invention has at least one functional group (hereinafter referred to as a functional group M) selected from -COOH, -SO₃H, -OP(=O)(OH)₂, -NR₂ and -N⁺R₃Cl⁻ (wherein R represents a C₁₋₄ alkyl group).

The functional group M is preferably -COOH or -SO₃H. When the fluoropolymer has such a functional group, the composition for a photoresist protective film will be excellent in solubility in an alkali developer.

The fluoropolymer is preferably a polymer (hereinafter referred to as a fluoropolymer (A)) having repeating units based on a monomer containing a functional group M and a fluorine atom or a copolymer (hereinafter referred to as a fluoropolymer (B)) having repeating units based on a monomer containing a functional group M and containing no fluorine atom and repeating units based on a monomer containing a fluorine atom and containing no functional group M.

The fluoropolymer (A) is a polymer having repeating units based on a monomer containing a functional group M and a fluorine atom, and the repeating units are preferably repeating units represented by the following formula 1 (hereinafter referred to as units 1) or repeating units represented by the following formula 2 (hereinafter referred to as units 2), more preferably units 1:

-CF₂CF[O(CF₂CF(CF₃)O)ₚ(CF₂)_{q}W]- Formula 1

-CF₂CF[(CF₂)ᵣW]- Formula 2

wherein each of p and q which are independent of each other, represents 0 or an integer of from 1 to 5, r represents 0 or an integer of from 1 to 10, and W represents -COOH or -SO₃H.

Specifically, the units 1 are preferably

-CF₂CF[OCF₂CF₂CF₂COOH]-,

-CF₂CF[OCF₂CF(CF₃)OCF₂CF₂COOH]-,

-CF₂CF[OCF₂CF(CF₃)OCF₂CF₂CF₂COOH]-,

-CF₂CF[OCF₂CF(CF₃)OCF₂CF₂SO₃H]- or the like. Specifically, the units 2 are preferably -CF₂CF[COOH]-, -CF₂CF[CF₂COOH]-, -CF₂CF[(CF₂)₂COOH]- or the like.

The fluoropolymer (A) is preferably a copolymer having repeating units (hereinafter referred to as units 3) in addition to the units 1 or the units 2. As a monomer forming the units 3, preferred is a monomer having an ethylenically unsaturated bond substituted by fluorine. Further, such a monomer may contain an etheric oxygen atom.

The following compounds may be mentioned as specific examples of such a monomer (s represents an integer of from 1 to 10) :

CF₂=CF₂,

CF₂=CFCF₃,

CF₂=CFCF₂(CF₂)_{S}F,

CF₂=CH₂,

CH₂=CH(CF₂)_{S}F,

CH₂=CHCH₂(CF₂)_{S}F,

CF₂=CFO(CF₂)_{S}F,

CF₂=CFOCH₂(CF₂)_{S}F,

CF₂=CFO(CF₂)_{S}CF=CF₂,

CF (CF₃)=CFO(CF₂)_{S}CF=CF₂,

CF₂=CFO(CF₂)_{S}CF=CFCF₃,

CF₂=CFOCF(CF₃)CF=CF₂,

CF₂=CFOCF₂CF(CF₃)CF=CF₂,

CF₂=CFOCF(CF₃)(CF₂)_{S}CF=CF₂,

CF₂=CFOC(CF₃)₂(CF₂)_{S}CF=CF₂.

Such a monomer is more preferably CF₂=CF₂ or CF₂=CFOCF₂CF₂CF=CF₂.

The fluoropolymer (A) is more preferably a copolymer having repeating units based on -CF₂CF[OCF₂CF₂CF₂COOH]- and CF₂=CF₂ or a copolymer having repeating units based on

-CF₂CF[OCF₂CF₂CF₂COOH]- and CF₂=CFOCF₂CF₂CF=CF₂

.

In the fluoropolymer (A), the proportion of the units 1 or the units 2 is preferably from 10 to 90 mol%, more preferably from 30 to 90 mol%. Further, the proportion of the units 3 is preferably from 90 to 10 mol%, more preferably from 70 to 10 mol%. Within this range, a photoresist protective film to be formed will be excellent in solubility in an alkali developer, excellent in insolubility in water or a liquid containing water as the main component, and excellent in water repellency.

The fluoropolymer (B) is a copolymer having repeating units (hereinafter referred to as units 4) based on a monomer containing a functional group M and containing no fluorine atom and repeating units (hereinafter referred to as units 5) based on a monomer containing a fluorine atom and containing no functional group M.

The monomer containing a functional group M and containing no fluorine atom is preferably a monomer containing a functional group M and a polymerizable functional group. The functional group M is the same as the above-mentioned functional group M. The polymerizable functional group is preferably CH₂=CR'-, CH₂=CR'COO-, CH₂=CR'OCO-, CH₂=CR'-Φ-CH₂O-, CH₂=CHO-CH₂=CR'CONH- (wherein R' represents a hydrogen atom, a methyl group or a halogen atom, and Φ represents a phenylene group, the same applies hereinafter) or the like, and it is more preferably CH₂=CR'COO-.

Specifically, the monomer containing a functional group M and containing no fluorine atom is preferably CH₂=CR'COOH, CH₂=CR'COOCH₂CH₂OCOR¹COOH, CH₂=CR'COOCH₂CH₂N(R²)₂, CH₂=CR'COOCH₂CH₂N⁺(R²)₃·Cl-, CH₂=CR'COOCH₂CH₂OPO(OH)₂, CH₂=CR'CON(R²)R¹SO₃H (wherein R' is as defined above, R¹ represents an alkylene group, a cycloalkylene group or an arylene group, and R² represents a hydrogen atom or a C₁₋₅ alkyl group) or the like, and it is more preferably CH₂=CHCOOH, CH₂=C(CH₃)COOH or CH₂=CHCONHC(CH₃)₂SO₃H.

The monomer containing a fluorine atom and containing no functional group M is preferably a monomer containing a polyfluoroalkyl group (hereinafter referred to as R^{f} group).

The monomer containing an R^{f} group and containing no functional group M (hereinafter referred to as an R^{f} monomer) is preferably a compound represented by X(Y-Z)ₙ (wherein X represents a polymerizable functional group, Y represents a bivalent organic group or a single bond, Z represents a C₁₋₂₀ R^{f} group, and n represents 1 or 2). When n is 2, (Y-Z) may be the same or different.

When n is 1, X is preferably a carbon-carbon unsaturated bond, and specifically, it is preferably a vinyl group (CH₂=CR'-), a vinyloxy group (CH₂=CHO-), a vinyloxycarbonyl group (CH₂=CR'OCO-), a (meth)acryloyloxy group (CH₂=CR'COO-), a residue of a maleate or fumarate (-OCOCH=CHCOO-), CH₂=CR'-Φ-CH₂O- (wherein R' and Φ are as defined above) or the like.

When n is 2, X is preferably CH₂=CR'(CH₂)ₘCH=, CH₂=CR'COO(CH₂)ₘCH=, CH₂=CR'OCO(CH₂)ₘCH=, -OCOCH=CHCOO-(wherein R' is as defined above, and m represents 0 or an integer of from 1 to 4) or the like.

X is more preferably CH₂=CR'COO- in view of excellent copolymerizability with another polymer.

Y may, for example, be a single bond, an alkylene group, -O-, -NH-, -CO-, -SO₂-, -CD¹=CD²- (wherein each of D¹ and D² which are independent of each other, represents a hydrogen atom or a methyl group) or -R^{M}-Q-R^{N}- (wherein each of R^{M} and R^{N} which are independent of each other, represents a single bond, a C₁₋₂₂ saturated or unsaturated hydrocarbon group which may contain one or more oxygen atoms, and Q represents a single bond, -OCONH-, -CONH-, -SO₂NH- or -NHCONH-).

Specifically, Y may, for example, be a single bond, -CH₂-, -CH₂CH₂- -CH₂CH₂CH₂-, -(CH₂)₁₁-, -CH₂CH₂CH(CH₃)-, -CH=CHCH₂-, -(CH₂CH₂O)ₜCH₂CH₂-, -[CH₂CH(CH₃)O]ₜCH₂CH₂₋ (wherein t is an integer of from 1 to 10), -C₂H₄OCONHC₂H₄-, -C₂H₄OCOOC₂H₄- or COOC₂H₄-. Y is preferably an alkylene group, more preferably -CH₂-, -CH₂CH₂- or -CH₂CH₂CH₂-.

The R^{f} group is a group having some or all of hydrogen atoms in an alkyl group substituted by fluorine atoms, and has preferably from 1 to 20, more preferably from 3 to 12, carbon atoms. The R^{f} group may contain one or more unsaturated groups such as a carbon-carbon unsaturated double bond.

The R^{f} group is preferably a group having at least 20 to 80% of the number of hydrogen atoms in an alkyl group substituted by fluorine atoms. Further, some or all of the remaining hydrogen atoms may be substituted by chlorine atoms. The R^{f} group preferably has a straight chain structure or a branched structure, and in a case where it has a branched structure, it preferably has a short branch at the terminal or in the vicinity thereof which is distant from the bond.

The R^{f} group is preferably a perfluoroalkyl group (hereinafter referred to as R^{F} group) having all the hydrogen atoms in an alkyl group substituted by fluorine atoms. The R^{f} group is more preferably a C₁₋₂₀ R^{F} group, most preferably a group represented by F(CF₂)ₕ- (wherein h is an integer of from 1 to 20) or a group represented by CⱼF₂ⱼ₊₁(CM¹M²CM³M⁴)ᵢ- (wherein each of M¹, M², M³ and M⁴ which are independent of one another, is a hydrogen atom, a fluorine atom or a chlorine atom, and at least one of them is a fluorine atom, and j and i are respectively integers of at least 1 and satisfy 20≧(j+2×i)≧6).

Specifically, the following groups are mentioned as preferred R^{F} groups.

F(CF₂)₄-, F(CF₂)₅-, F(CF₂)₆-, (CF₃)₂CF(CF₂)₂-, H(CF₂)₆-, H(CF₂)₂-, Cl(CF₂)₄-, F(CF₂)₄(CH₂CF₂)₃-, F(CF₂)₆(CH₂CF₂)₃-, F (CF₂)₄(CFClCF₂)₂-, CF₃CF=CFCF₂CF=CF-, CH(CF₃)(CF₂CF₃)(CF₃CF₂)C(CF₃)-, CₖF₂ₖ₊₁O[CF(CF₃)CF₂O]₁CF(CF₃)- and C₃F₇O[CF(CF₃)CF₂O]ₕ(CF₂)ᵥ- (wherein k represents an integer of from 3 to 6, 1 represents 0 or an integer of from 1 to 3, h represents 0 or an integer of from 1 to 3, and v represents an integer of from 1 to 6).

The R^{f} monomer is preferably CH₂=CHCOOC₂H₄(CF₂)₄F, CH₂=C(CH₃)COOC₂H₄(CF₂)₄F, CH₂=CHCOOC₂H₄(CF₂)₆F, CH₂=C(CH₃)COOC₂H₄(CF₂)₆F, CH₂=CHCOOC₂H₄(CF₂)₈F, CH₂=C(CH₃)COOC₂H₄(CF₂)₈F, CH₂=CHCOOCH₂(CF₂)₇F or the like.

The fluoropolymer (B) may have repeating units (hereinafter referred to as units 6) based on a monomer other than monomers forming the above units 4 and 5. Such a monomer is preferably a (meth)acrylate in view of excellent copolymerizability. Further, in view of excellent solubility and excellent film-formation properties when a protective film is formed, it is preferably an alkyl (meth)acrylate, an aryl (meth)acrylate, a polyoxyalkylene (meth)acrylate, a hydroxyalkyl (meth)acrylate or the like. Specifically, the monomer is preferably methyl (meth)acrylate, ethyl (meth)acrylate, cyclohexyl (meth)acrylate, 2-ethylhexyl (meth)acrylate, hexadecyl (meth)acrylate, octadecyl (meth)acrylate, 2-hydroxyethyl (meth)acrylate, polyoxyethylene polyoxypropylene glycol monomethyl ether (meth)acrylate, polyoxyethylene polyoxypropylene glycol mono(meth)acrylate or the like.

The fluoropolymer (B) is preferably a copolymer having repeating units based on CH₂=CHCOOH, CH₂=C(CH₃)COOH, CH₂=CHCONHC(CH₃)₂SO₃H or the like and having repeating units based on the R^{f} monomer such as CH₂=CHCOO(CF₂)₄F, CH₂=C(CH₃)COO(CF₂)₄F, CH₂=CHCOO(CF₂)₆F, CH₂=C(CH₃)COO(CF₂)₆F, CH₂=CHCOO(CF₂)₈F or CH₂=C(CH₃)COO(CF₂)₈F.

In the fluoropolymer (B), the proportion of the units 4 to the units 5 is preferably 1 to 99/99 to 1, more preferably 10 to 90/90 to 10 by mass ratio. Within this range, a photoresist protective film to be formed will be excellent in water repellency, will be insoluble in water or a liquid containing water as the main component and will be excellent in solubility in an alkali developer.

The weight average molecular weight Mw of the fluoropolymer of the present invention is from 1,000 to 100,000, preferably at most 80,000 in view of excellent solubility in an alkali developer, more preferably at most 50,000. Further, in view of excellent film-formation properties when a photoresist protective film is formed by using the composition for a photoresist protective film, it is preferably at least 5,000, more preferably at least 6,000. The weight average molecular weight Mw of the fluoropolymer is most preferably from 8,000 to 40,000.

The method for producing the fluoropolymer is not particularly limited, and the fluoropolymer (A) and the fluoropolymer (B) are produced preferably by the following methods (a) and (b), respectively.

Method (a): A method of polymerizing a fluoromonomer having a functional group capable of being converted into a functional group M, and then converting functional groups capable of being converted into functional groups M into functional groups M.

Method (b): A method of copolymerizing a monomer containing a functional group M and containing no fluorine atoms and an R^{f} monomer.

Specifically, the method (a) is preferably a method of polymerizing CF₂=CF[O(CF₂CF(CF₃)O)ₚ(CF₂)_{q}COOCH₃] (wherein p and q are as defined above) or CF₂=CF[(CF₂)ᵣCOOCH₃] (wherein r is as defined above) and then hydrolyzing the -COOCH₃ moiety, a method of polymerizing CF₂=CF[O(CF₂CF(CF₃)O)ₚ(CF₂)_{q}SO₂F] (wherein p and q are as defined above) or CF₂=CF[(CF₂)ᵣSO₂F] (wherein r is as defined above) and then hydrolyzing the -SO₂F moiety, or the like.

Specifically, the method (b) is preferably a method of polymerizing CH₂=CHCOOH and CH₂=CHCOOC₂H₄(CF₂)₄F, or the like.

The polymerization method for the methods (a) and (b) is not particularly limited, and radical polymerization wherein a radical polymerization initiator is added to the above monomer, followed by heating is preferred. The radical polymerization initiator is preferably a peroxide, an azo compound or the like. The peroxide may, for example, be preferably a peroxyketal, a diacylperoxide, a peroxycarbonate or a peroxyester. The azo compound may, for example, be preferably an azonitrile, an azoamide or an azoamidine.

The following compounds may be preferably mentioned as specific examples of the radical polymerization initiator.

Peroxyketals such as 1,1-bis(t-butylperoxy)-3,3,5-trimethylcyclohexane, 1,1-bis(t-butylperoxy)cycolhexane, n-butyl-4,4-bis(t-butylperoxy)pentanoate, 2,2-bis(t-butylperoxy)butane, 1,1-bis(t-hexylperoxy)-3,3,5-trimethylcyclohexane, 1,1-bis(t-hexylperoxy)cyclohexane, 1,1-bis(t-hexylperoxy)cyclododecane and 2,2-bis(4,4-di-t-butylperoxycyclohexyl)propane.

Diacylperoxides such as perfluorobutanoyl peroxide, isobutyryl peroxide, lauroyl peroxide, 3,5,5-trimethylhexanoyl peroxide, succinic acid peroxide, benzoyl peroxide, octanoyl peroxide and stearoyl peroxide.

Peroxydicarbonates such as diisopropyl peroxydicarbonate, di-2-ethylhexyl peroxydicarbonate, din-propyl peroxydicarbonate, di-2-ethoxyethyl peroxydicarbonate, di-3-methoxybutyl peroxydicarbonate and bis-(4-t-butylcyclohexyl) peroxydicarbonate.

Peroxyesters such as 1,1,3,3-tetramethylbutyl peroxyneodecanoate, t-hexyl peroxyneodecanoate, t-butyl peroxyneodecanoate, t-hexyl peroxypivalate, t-butyl peroxypivalate, 1,1,3,3-tetramethylbutyl peroxy-2-ethylhexanoate, t-hexyl peroxy-2-ethylhexanoate, t-butyl peroxy-2-ethylhexanoate, t-butyl peroxyisobutyrate, t-butyl_ peroxylaurate, t-butyl peroxy-3,5,5-trimethylhexanoate, t-hexyl peroxyisopropylmonocarbonate, t-butyl peroxyisopropylcarbonate, 2,5-dimethyl-2,5-bis(benzoylperoxy)hexane, t-butyl peroxyacetate and bis-t-butyl peroxyisophthalate.

As the inorganic peroxide, ammonium persulfate, potassium persulfate or the like may be preferably mentioned.

Azonitriles such as 2,2'-azobis(4-methoxy-2,4-dimethylvaleronitrile), 2,2'-azobis(2,4-dimethylvaleronitrile), 2,2'-azobis(2-methylpropionitrile), 2,2'-azobis(2-methylbutyronitrile), 1,1'-azobis(cyclohexane-1-carbonitrile) and 1-[1-cyano-1-methylethylazo]formamide (2-(carbamoylazo)isobutyronitrile).

Azoamides such as 2,2'-azobis{2-methyl-N-[1,1-bis(hydoxymethyl)-2-hydroxyethyl]propionamide}, 2,2'-azobis{2-methyl-N-[2-(1-hydroxybutyl)]-propionamide}, 2,2'-azobis[2-methyl-N-(2-hydroxyethyl)-propionamide], 2,2'-azobis[N-(2-propenyl)-2-methylpropionamide] and 2,2'-azobis[2-(2-imidazolin-2-yl)propane].

Azoamidines such as 2,2'-azobis(2-methylpropionamidine) and 2,2'-azobis[N-(2-hydroxyethyl)-2-methyl-propionamidine].

Azo compounds such as dimethyl-2,2'-azobis(2-methylpropionate) and 4,4'-azobis(4-cyanopentanoic acid).

The amount of the polymerization initiator used is preferably from 0.01 to 3 mol% based on the total number of moles of the monomers.

A chain transfer agent may be used for the polymerization reaction. The chain transfer agent may, for example, be preferably an alcohol such as methanol or ethanol, a hydrocarbon such as heptane, n-hexane or cyclohexane or a mercaptan such as dodecylmercaptan. The amount of the chain transfer agent used is preferably from 0.01 to 10 mol% based on the total number of moles of the monomer.

A medium may be or may not be used for the polymerization reaction. When it is used, it is preferably a medium in which the fluoromonomer is dissolved or dispersed. The medium is preferably water, a halogen compound or the like.

The halogen compound is preferably a halogenated hydrocarbon, a halogenated ether, a halogenated amine or the like. The halogenated hydrocarbon is preferably a hydrochlorofluorocarbon, a hydrofluorocarbon, a perfluorocarbon or the like.

The hydrochlorofluorocarbon is preferably CH₃CCl₂F, CHCl₂CF₂CF₃, CHClFCF₂CClF or the like.

The hydrofluorocarbon is preferably a C₄₋₆ chain compound or cyclic compound.

The C₄ chain compound may, for example, be CF₃CF₂CF₂CHF₂, CF₃CF₂CF₂CH₂F, CF₃CF₂CH₂CF₃, CHF₂CF₂CF₂CHF₂, CHF₂CH₂CF₂CF₃, CF₃CHFCH₂CF₃, CF₃CH₂CF₂CHF₂, CHF₂CHFCF₂CHF₂, CF₃CHFCF₂CH₃, CHF₂CHFCHFCHF₂, CF₃CH₂CF₂CH₃, CF₃CF₂CH₂CH₃ or CHF₂CH₂CF₂CH₃.

The C₅ chain compound may, for example, be CHF₂CF₂CF₂CF₂CF₃, CF₃CF₂CF₂CHFCF₃, CHF₂CF₂CF₂CF₂CHF₂, CF₃CHFCHFCF₂CF₃, CF₃CHFCF₂CH₂CF₃, CF₃CF(CF₃)CH₂CHF₂, CF₃CH(CF₃)CH₂CF₃, CF₃CH₂CF₂CH₂CF₃, CHF₂CHFCF₂CHFCHF₂, CHF₂CF₂CF₂CHFCH₃, CF₃CH₂CH₂CH₂CF₃ or CHF₂CH₂CF₂CH₂CHF₂.

The C₆ chain compound may, for example, be CF₃(CF₂)₄CHF₂, CF₃(CF₂)₄CH₂F, CF₃CF₂CF₂CF₂CH₂CF₃, CHF₂CF₂CF₂CF₂CF₂CHF₂, CF₃CH(CF₃)CHFCF₂CF₃, CF₃CF₂CH₂CH(CF₃)CF₃, CF₃CH₂CF₂CF₂CH₂CF₃, CF₃CF₂CH₂CH₂CF₂CF₃, CF₃CF₂CF₂CF₂CH₂CH₃, CF₃CH(CF₃)CH₂CH₂CF₃, CHF₂CF₂CH₂CH₂CF₂CHF₂ or CF₃CF₂CF₂CH₂CH₂CH₃.

The cyclic compound may, for example, be 1,2-dihydroperfluoropentane, 1,2-dihydroperfluorohexane or 1,1,2,2-tetrahydroperfluorohexane.

The perfluorocarbon is preferably C₆F₁₄, C₇F₁₆, C₈F₁₈, C₉F₂₀ or the like.

The halogenated ether may, for example, be a hydrofluoroether or a perfluoroether. The hydrofluoroether is preferably a separated hydrofluoroether, a non-separated hydrofluoroether or the like.

The separated hydrofluoroether is a compound wherein a perfluoroalkyl group or a perfluoroalkylene group and an alkyl group or an alkylene group are bonded via an etheric oxygen atom. The non-separated hydrofluoroether is a hydrofluoroether containing a partially fluorinated alkyl group or alkylene group.

The separated hydrofluoroether is preferably CF₃CF₂CF₂OCH₃, (CF₃)₂CFOCH₃, CF₃CF₂CF₂OCH₂CH₃, CF₃CF₂CF₂CF₂OCH₃, (CF₃)₂CFCF₂OCH₃, (CF₃)₃COCH₃, CF₃CF₂CF₂CF₂OCH₂CH₃, (CF₃)CFCF₂OCH₂CH₃, (CF₃)₃COCH₂CH₃, CF₃CF(OCH₃)CF(CF₃)₂, CF₃CF(OCH₂CH₃)CF(CF₃)₂, C₅F₁₁OCH₂CH₃, CF₃CF₂CF₂CF(OCH₂CH₃)CF(CF₃)₂, CH₃O(CF₂)₄OCH₃, CH₃OCF₂CF₂OCH₂CH₃, C₃H₇OCF(CF₃)CF₂OCH₃ or the like.

The non-separated hydrofluoroether is preferably CHF₂OCF₂OCHF₂, CH₂FCF₂OCHF₂, CF₃CF₂CF₂OCH₂F, CF₃CF₂OCH₂CHF₂, CHF₂CF₂CH₂OCF₃, CF₃CF₂CH₂OCHF₂, CHF₂CF₂OCH₂CHF₂, CF₃CH₂OCF₂CH₂F, CF₃CH₂OCF₂CHF₂, CHF₂CF₂CF₂OCH₃, HF₂CF₂CH₂OCH₃, CF₃CF₂CF₂OCH₂CF₃, CF₃CF₂CH₂OCF₂CF₃, CF₃CF₂CF₂OCH₂CHF₂, CF₃CF₂CH₂OCF₂CHF₂, CHF₂CF₂CH₂OCF₂CF₃, CHF₂CF₂CH₂OCF₂CHF₂, CF₃CHFCF₂CH₂OCF₃, CF₃CHFCF₂CH₂OCHF₂, CF₃CF₂CF₂CH₂OCH₃, (CF₃)₂CHCF₂OCH₃, CF₃CF₂CF₂OCH₂CF₂CF₃, CF₃CF₂CF₂OCH₂CF₂CHF₂, CF₃CF₂CF₂CF₂OCF₂CHF₂, CF₃(CF₂)₅OCHF₂, CHF₂OCF₂CF₂OCHF₂, CHF₂OCF₂OCF₂CF₂OCHF₂, CHF₂OCF₂OCF₂OCF₂OCHF₂ or the like.

The perfluoroether is preferably perfluoro(2-butyltetrahydrofuran), CF₃(CF₂)₃OCF₂CF₃, CF₃(CF₂)₃O(CF₂)₃CF₃ or the like.

The halogenated amine is preferably tris(perfluorobutyl)amine or the like.

The halogen compound may be a commercial one, and the following compounds may be preferably mentioned as commercial products.

Asahiklin AK-225 and AE-3000, Aflude E-10, E-16 and E-18 (manufactured by Asahi Glass Company, Limited).

Fluorinert PF-5060, PF-5070, PF-5080, PC-72, PC-75, FC-40, FC-43, FC-70, FC-71, FC-75 and FC-77 (manufactured by Sumitomo 3M Limited).

FLUTEC PP-50, PP-1, PP-2, PP-3, PP-5 and PP-9 (manufactured by F2 Chemicals Limited).

Perflude IL-310, IL-270 and IL-260 (manufactured by Tokuyama Corporation).

EFTOP EF-L102, EF-L174 and EF-L100 (manufactured by JEMCO Inc.).

GALDEN HT70, HT110, HT135, HT200, HT230, HT270, D01, D02, LS155, SL230 and HS260 (manufactured by Solvay Solexis, Inc).

The composition for a photoresist protective film of the present invention comprises a solvent. The solvent is preferably a solvent containing at least one member selected from the group consisting of water, an alcohol and a fluorine-containing solvent. When such a solvent is used, the influence over a photoresist layer at the time of coating can be minimized. The alcohol may, for example, be ethanol, 2-propanol or a glycol such as propylene glycol. The fluorine-containing solvent is preferably a hydrofluorocarbon, a perfluorocarbon, a perfluoroether or the like, more preferably CF₃(CF₂)₄CHF₂, CF₃(CF₂)₅CHF₂, CF₃(CF₂)₄CHFCF₃, CF₃(CF₂)₆CF₃ or perfluoro(2-butyltetrahydrofuran). The composition for a photoresist protective film preferably comprises the above solvent alone, but may contain a solvent other than the above solvent.

The content of the fluoropolymer in the composition for a photoresist protective film of the present invention is not particularly limited so long as the fluoropolymer is dissolved, and it is set so that a protective film having a desired thickness can be formed by coating. The content of the fluoropolymer in the composition for a photoresist protective film is preferably from 0.05 to 10 mass%, more preferably from 0.1 to 5 mass%.

The composition for a photoresist protective film of the present invention may contain an acid or a base for the purpose of suppressing migration of an acid generator from the photoresist layer or for another purpose. The acid is not particularly limited, and a carboxylic acid, a sulfonic acid, a phosphonic acid, an amino acid, an aminosulfonic acid, sulfuric acid or phosphoric acid may, for example, be preferably mentioned.

Carboxylic acids such as formic acid, acetic acid, propionic acid, butyric acid, isobutyric acid, methoxyacetic acid, oxalic acid, malonic acid, succinic acid, lactic acid, malic acid, adipic acid and citric acid.

Sulfonic acids such as methanesulfonic acid and dodecylbenzenesulfonic acid.

Phosphonic acids such as phenylphosphonic acid.

Amino acids such as alanine, valine, leucine, isoleucine, proline, methionine, glycine, serine, asparagine, glutamine, arginine, threonine, cysteine, lycine, asparaginic acid, glutamic acid, histidine, N,N-bis(2-hydroxyethyl)glycine, N-[tris(hydroxymethyl)methyl]glycine and betaine.

Aminosulfonic acids such as sulfamic acid, N-(2-acetamide)-2-aminoethanesulfonic acid, N,N-bis(2-hydroxyethyl)-2-aminoethanesulfonic acid, N-cyclohexyl-3-aminopropanesulfonic acid, N-cyclohexyl-2-hydroxy-3-aminopropanesulfonic acid, N-cyclohexyl-2-aminoethanesulfonic acid, 3-[N,N-bis(2-hydroxyethyl)amino]-2-hydroxypropanesulfonic acid, 3-[4-(2-hydroxyethyl)-1-piperazinyl]propanesulfonic acid, 2-[4-(2-hydroxyethyl)-1-piperazinyl]ethanesulfonic acid, 2-hydroxy-3-[4-(2-hydroxyethyl)-1-piperazinyl]propanesulfonic acid, 2-morpholinoethanesulfonic acid, 3-morpholinopropanesulfonic acid, 2-hydroxy-3-morpholinopropanesulfonic acid, piperazine-1,4-bis(2-ethanesulfonic acid), N-tris(hydroxymethyl)methyl-3-aminopropanesulfonic acid, 2-hydroxy-N-tris(hydroxymethyl)methyl-3-aminopropanesulfonic acid and N-tris(hydroxymethyl)methyl-2-aminoethanesulfonic acid.

The base is not particularly limited, and an amine or an ammonium salt may, for example, be preferably mentioned, and a monoethanolamine, tetraammonium hydroxide or the like is preferred.

The composition for a photoresist protective film of the present invention may contain various functional additives. It may contain a polymer other than the fluorocopolymer of the present invention for the purpose of improving film-formation properties. Further, it may contain a surfactant for the purpose of improving leveling properties and wettability to the photoresist layer.

Such a polymer may, for example, be preferably a polyvinylpyrrolidone, a polyacrylic acid or a polyvinyl alcohol. The surfactant may, for example, be preferably a compound having a polyfluoroalkyl group and a polyoxyethylene group (Fluorad "FC-430" or "FC-4430" manufactured by Sumitomo 3M Limited, "S-393" manufactured by SEIMI CHEMICAL Co., Ltd., etc.), a compound having polyoxyethylene added to acetylene glycol ("Surfynol104", "Surfynol420" manufactured by Air Products and Chemicals, Inc.) or a polyglycerol fatty acid ester.

The photoresist protective film for immersion lithography of the present invention is formed by using the composition for a photoresist protective film. In an immersion lithography process, water or a liquid containing water present at a space between a photoresist layer and a projection lens is required to follow the movement of the projection lens and thereby preferably contains an alcohol, more preferably contains 2-propanol.

As a coating method for forming a photoresist protective film by using the composition for a photoresist protective film of the present invention, spin coating is preferred in view of excellent uniformity of a coating film and simplicity. Further, it is preferred to carry out drying by e.g. a hotplate or an oven for the purpose of removing the solvent after coating. The drying is carried out preferably under conditions at from 70 to 100°C for from 30 to 180 seconds.

The photoresist pattern formation process of the present invention is preferably a process which comprises forming a photoresist layer on the surface of a substrate, forming the photoresist protective film of the present invention thereon to obtain a photoresist substrate, exposing the photoresist substrate by an immersion lithography process, and carrying out an alkali development. A light to be used in the immersion lithography process is not particularly limited, and an excimer laser such as KrF or ArF may be used.

Now, the present invention will be explained in detail with reference to Examples of the present invention (Examples 1 and 2) and a Comparative Example (Example 3). However, it should be understood that the present invention is by no means restricted to such specific Examples.

With respect to a formed photoresist protective film, solubility in water and solubility in an alkali developer were evaluated. The evaluation methods are as follows. The weight average molecular weight Mw was measured by means of gel permeation chromatography and is represented by a value as calculated as polymethyl methacrylate.

### METHOD FOR EVALUATING SOLUBILITY

Coating conditions of a spin coater are adjusted so that the thickness after coating will be from 100 to 200 nm. The surface of a silicon wafer is coated with a composition for a photoresist protective film by means of a spin coater having conditions adjusted, to obtain a silicon wafer having a protective film formed thereon. The thickness of the protective film (hereinafter this thickness will be referred to as thickness A) is measured by means of an ellipsometer.

Then, the obtained silicon wafer is immersed in water for 30 minutes, taken out and dried, and then the thickness of the protective film (hereinafter this thickness will be referred to as thickness B) is measured by means of an ellipsometer.

Then, the silicon wafer is immersed in a 2.38 mass% tetrahydroammonium hydroxide aqueous solution which is an alkali developer for 30 seconds, taken out and dried, and then the thickness of the protective film (hereinafter this thickness will be referred to as thickness C) is measured by means of an ellipsometer.

In a case where the thickness B is at least 95% of the thickness A, and no damage is visually confirmed on the protective film, the protective film is rated "insoluble in water". Further, in a case where the thickness C is at most 50% of the thickness B, and it is visually confirmed that the protective film is disappeared, the protective film is rated "soluble in an alkali developer", and in other cases, the protective film is rated "insoluble in an alkali developer".

### EXAMPLE 1

Into a 200 mL autoclave, 18.4 g of 2-(perfluorohexyl)ethyl acrylate, 1.36 g of acrylic acid, 0.65 g of 2-acrylamide-2-methylpropanesulfonic acid, 44.6 g of acetone, 14.8 g of methanol and 0.15 g of dimethyl-2,2'-azobis(2-methylpropionate) were charged, the air in the system was replaced with nitrogen, and a reaction was carried out at 65°C for 15 hours to obtain a reaction liquid.

The obtained reaction liquid was dried at room temperature under reduced pressure to obtain 20 g of a fluoropolymer 1. The yield of the fluoropolymer 1 was 98%, and the weight average molecular weight Mw of the fluoropolymer 1 was 3×10⁴.

The fluoropolymer 1 was dissolved in CF₃(CF₂)₄CHF₂ to prepare a 3 mass% solution, which was used to form a protective film on a silicon wafer. The obtained protective film was insoluble in water and soluble in an alkali developer. Further, the protective film provided a contact angle to water of 110°.

### EXAMPLE 2

Into a 200 mL autoclave, 20 g of CF₂=CFOCF₂CF₂CF₂COOCH₃ (hereinafter referred to as PFA), 20 g of CF₂=CFOCF₂CF₂CF=CF₂ (hereinafter referred to as PFB) and 0.23 g of diisopropyl peroxydicarbonate (hereinafter referred to as IPP) were charged, the air in the system was replaced with nitrogen, and further, the pressure was elevated to 0.2 MPa, the temperature was increased to 40°C, and a reaction was carried out at 40°C for 24 hours to obtain a reaction liquid.

Unreacted monomers were distilled off from the obtained reaction liquid, and the reaction liquid was dried at room temperature under reduced pressure to obtain 25 g of a fluoropolymer 2. The yield of the fluoropolymer 2 was 63%, and the weight average molecular weight Mw was 2×10⁴. Water was put in the fluoropolymer 2, followed by heating to 80°C, and hydrolysis was carried out to obtain a hydrolyzate. Carboxyl groups in the hydrolyzate were titred with an alkali to determine the composition (molar ratio) of a copolymer in the hydrolyzate, whereupon the repeating units derived from PFA/repeating units derived from PFB=7/3.

The hydrolyzate was dissolved in a solvent comprising water and 2-propanol in a mass ratio of 90/10 to prepare a 3 mass% solution, which was used to form a protective film on a silicon wafer. The obtained protective film was insoluble in water and soluble in an alkali developer. Further, the protective film provided a contact angle to water of 93°.

### EXAMPLE 3

Into a 200 mL autoclave, 40 g of PFB and 0.23 g of IPP were charged, the air in the system was replaced with nitrogen, and then the pressure was elevated to 0.2 MPa, the temperature was increased to 40°C, and a reaction was carried out at 40°C for 24 hours to obtain a reaction liquid. Unreacted monomers were distilled off from the obtained reaction liquid, and the reaction liquid was dried at room temperature under reduced pressure to obtain 20 g of a fluoropolymer 3. The yield of the fluoropolymer 3 was 50%, and the weight average molecular weight Mw was 3×10⁴.

The fluoropolymer 3 was dissolved in CF₃(CF₂)₆CF₃ to prepare a 3 mass% solution, which was used to form a protective film on a silicon wafer. The obtained protective film was insoluble in water and insoluble in an alkali developer.

The photoresist protective film of the present invention can be used as a photoresist protective film in an immersion lithography process. The composition for a photoresist protective film of the present invention can be used for forming a photoresist protective film to be used for an immersion lithography process. Further, a photoresist pattern can be formed on a photoresist substrate having the photoresist protective film of the present invention formed thereon by means of an immersion lithography process. Further, the composition for a photoresist protective film can be used also for an antireflection film on the surface of a photoresist layer.

The entire disclosure of Japanese Patent Application No. 2004-223813 filed on July 30, 2004 including specification, claims and summary is incorporated herein by reference in its entirety.

## Claims

1. A composition for a photoresist protective film comprising a fluoropolymer having at least one functional group selected from the group consisting of -COOH, -SO₃H, -OP(=O)(OH)₂, -NR₂ and -N⁺R₃Cl⁻ (wherein R represents a C₁₋₄ alkyl group) and having a weight average molecular weight Mw of from 1,000 to 100,000 and a solvent.

2. The composition for a photoresist protective film according to Claim 1, wherein the solvent is a solvent containing at least one member selected from the group consisting of water, an alcohol and a fluorine-containing solvent.

3. The composition for a photoresist protective film according to Claim 1, wherein the fluorocopolymer is a polymer having repeating units based on a monomer containing a functional group M and a fluorine atom, or a copolymer having repeating units based on a monomer containing a functional group M and containing no fluorine atom and repeating units based on a monomer containing a fluorine atom and containing no functional group M.

4. The composition for a photoresist protective film according to Claim 3, wherein the repeating units based on a monomer containing a functional group M and a fluorine atom are repeating units represented by the following formula 1 or 2:-
CF₂CF[O(CF₂CF(CF₃)O)ₚ(CF₂)_{q}W]- Formula 1
-CF₂CF[(CF₂)ᵣW]- Formula 2
wherein each of p and q which are independent of each other, represents 0 or an integer of from 1 to 5, r represents 0 or an integer of from 1 to 10, and W represents -COOH or -SO₃H.

5. The composition for a photoresist protective film according to Claim 3, wherein the polymer having repeating units based on a monomer containing a functional group M and a fluorine atom is a copolymer further having repeating units based on a monomer having an ethylenically unsaturated bond substituted by fluorine.

6. The composition for a photoresist protective film according to Claim 3, wherein the solvent is a solvent containing at least one member selected from the group consisting of water, an alcohol and a fluorine-containing solvent.

7. The composition for a photoresist protective film according to Claim 3, which has a content of the fluorocopolymer of from 0.05 to 10 mass%.

8. A photoresist protective film for immersion lithography formed by using the composition for a photoresist protective film as defined in Claim 1.

9. A photoresist pattern formation process, which comprises forming a photoresist layer on the surface of a substrate and further forming the photoresist protective film as defined in Claim 8 thereon to obtain a photoresist substrate, exposing the photoresist substrate by an immersion lithography process, and carrying out an alkali development.

10. The photoresist pattern formation process according to Claim 9, wherein in the immersion lithography process, a liquid present at a space between the photoresist layer and a projection lens is a liquid containing an alcohol.
